Europäisches Patentamt

European Patent Office

Office européen des brevets

(11) Publication number: **0 246 447 B1**

# EUROPEAN PATENT SPECIFICATION

(45) Date of publication of patent specification: **15.01.92** (51) Int. Cl.⁵: **H01L 21/60**, G03F 7/26

(21) Application number: **87105552.1**

(22) Date of filing: **14.04.87**

(54) **Organic solder dam for a semiconductor device.**

(30) Priority: **06.05.86 US 860261**

(43) Date of publication of application:
**25.11.87 Bulletin 87/48**

(45) Publication of the grant of the patent:
**15.01.92 Bulletin 92/03**

(84) Designated Contracting States:
**DE FR GB IT**

(56) References cited:
**EP-A- 0 136 130**
**FR-A- 2 541 044**

**IBM TECHNICAL DISCLOSURE BULLETIN, vol. 18, no. 10, March 1976, page 3477, New York, US; L. KUHN et al.: "High-density, low-temperature solder reflow bonding of silicon chips to plastic substrates"**

**IBM TECHNICAL DISCLOSURE BULLETIN, vol. 23, no. 9, February 1981, page 4054, New York, US; K.M. GARDINER et al.: "Maskless solder bump interconnection process"**

(73) Proprietor: **International Business Machines Corporation**
**Old Orchard Road**
**Armonk, N.Y. 10504(US)**

(72) Inventor: **McBride, Donald Gene**
**2058 Cheshire Road**
**Binghamton, N.Y. 13 903(US)**
Inventor: **Shaw, Jane Margaret**
**49 Old Sib Road**
**Ridgefield, Conn. 06 877(US)**

(74) Representative: **Kreidler, Eva-Maria, Dr. rer. nat.**
**IBM Deutschland GmbH Patentwesen und Urheberrecht Schönaicher Strasse 220**
**W-7030 Böblingen(DE)**

EP 0 246 447 B1

## Description

This invention relates to a process for defining a solder dam utilizing a silylated photoresist. In joining a semiconductor chip to a substrate, a solder joint is employed to provide the necessary electric coupling between the microminiature semiconductor component and terminal metallurgy on the substrate surface. This invention is directed to a process and the resulting structure of employing a high temperature organic solder dam to isolate the terminal area on the substrate from the overflow of solder during the joining operation.

In the manufacture of semiconductor devices, a number of semiconductor chips are joined to a substrate. Typically, solder contacts are employed. Such are shown in U.S. Patents 3,392,442 and 3,495,133. The solder ball, generally comprising a solder alloy of tin and lead collapses in a controlled manner to provide the necessary connection. During this controlled collapse of the solder ball, it is necessary to provide a stop-off or solder dam to prevent solder material from spreading and typically running down the circuit line.

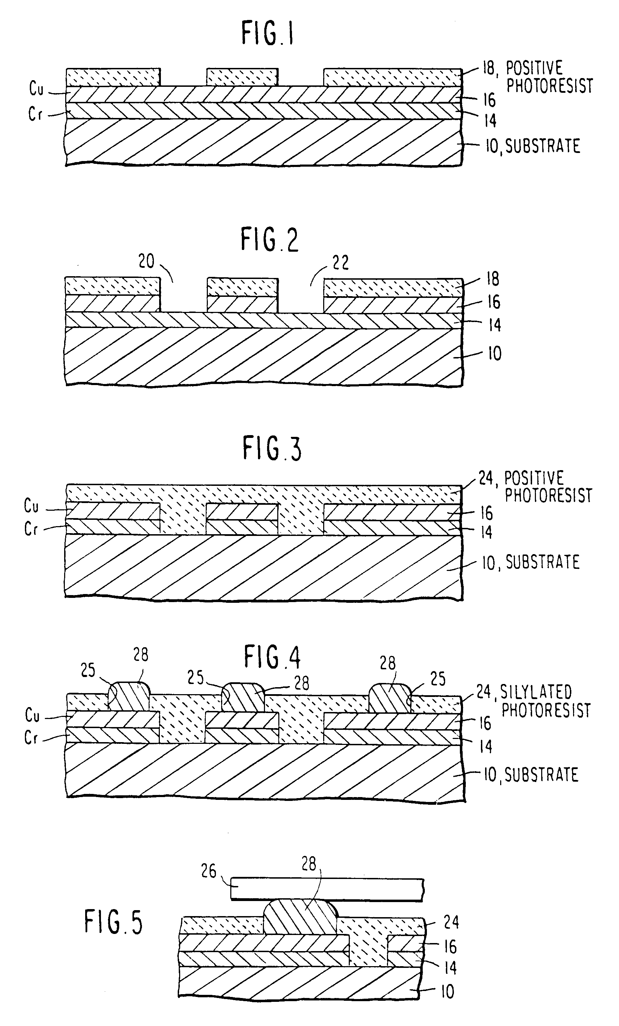

In US-A 3,392,442, the solder mounds are deposited respectively on a composite of contact metallization which comprises layers of chromium, copper, and gold which are vacuum deposited to provide the desired electrical contact to aluminum land 26. It is recognized in the art that the chromium deposit is necessary to establish the necessary isolation of the contact area such as clearly is illustrated in Figure 3 of US-A 3,392,422.

Reference is made to IBM Technical Disclosure Bulletin, Volume 16, No. 11, pp. 3610-3611 (April 1974). This TDB discloses techniques of joining semiconductor chips to a substrate by means of a lead-indium solder joint. It is recognized, where controlled collapse chip connections (C4) are employed, isolation of the terminal area is required. Consequently, glass is used in one embodiment, chromium in another, ceramic in a third and silicon dioxide in a fourth implementation of the isolation structure.

FR-A-2 541 044 A1 relates to a process for joining a chip to a substrate which comprises: coating a substrate with an isolating material and opening windows in said material over conductive lines; depositing solder in the area of said windows; positioning a chip over the substrate with the contacts of the chip being in alignment with the corresponding windows; heating the substrates such that the solder reflows to form a connection between substrate and chip; and allowing the solder to solidify. The isolating material is a photoepoxide which remains in place after solder reflow bonding.

IBM Technical Disclosure Bulletin Vol. 18, No. 10, March 1976, p. 3477, L. Kuhn et al, "High density, low-temperature solder reflow bonding of silicon chips to plastic substrates" discloses an electrical connection between a silicon chip and a plastic substrate where solder balls reflow upon heating to form a connection between the metal on the substrate and the metal pads on the silicon chip. The photoresist used for defining windows remains in place after soldering.

In another known process, chromium-copper-chromium blankets are successively deposited onto the substrate. The deposition may be vacuum deposition or sputtering. The first layer of the chromium acts as an adhesion barrier between the copper layer and the ceramic or polyimide forming the substrate material. The intermediate copper layer is the conducting circuit layer as in the case of US-A-3,392,442. The top chromium layer is employed as the solder stop-off or solder dam layer. Thus, as in the case of US-A-3,392,442, this solder dam prevents run off of solder from the solder ball forming the C4 interconnection from contaminating adjacent portions of the substrate. Typically, the solder during collapse tends to run down the circuit line of the chip to be interconnected, thereby ruining that chip. Consequently, as recognized in the art, the top chromium layer is the key to having control collapse of the solder ball in achieving positive chip connection without run-off.

In accordance with this technique and by the extension of that described in US-A-3,392,442, circuitization of the blanket layers, that is chromium-copper-chromium requires two complete photolithographic and etching processes. The first step defines the circuitry, or personalization and the second creates the solder dam. The second step is, therefore, a select etch. The photoresist of choice is currently KTFR (trademark of Kodak Co.), a negative photoresist which comprises a partially cyclized poly-cis-isoprene with an average unsaturation of one double bond per 10 carbon atoms and 2,6-bis(p-azidobenzylidene)-4-methylcyclohexane as sensitizer compound. Etchant of choice is $KMnO_4/KOH$ as a chromium etchant and $FeCl_3/HCl$ as the copper etchant.

One of the difficulties in using this choice of materials is the inability of achieving fine line resolution. Another problem is that of stripping. Consequently, within the technology, there exists a limitation on line resolution which may be achieved and, therefore, overall density of the device. The potential use of a positive photoresist would provide a solution. However, a positive photoresist cannot be used because it is incompatible with the use of the top chromium layer. The incompatibility is that when the chrome layer is etched the positive photoresist will also be etched in the same step. Thus, given the use of chromium, the only reliable etchant used to date has been

$KMnO_4/KOH$.

Another problem with the use of a negative photoresist such as KTFR is the use of the particular stripping material. J100 (trademark of Indust-Ri-Chem Lab., Richardson, Texas) which comprises the Na-salt of an alkyl naphthalene sulfonate, free sulfonic acid, and tetrachloroethylene, o- and p-dichlorobenzene, and phenol, is currently employed. This material is considered aggressive and presents environmental and health problems. Moreover, it must be used under extremely controlled conditions to prevent yield losses on the product.

Consequently, given the limitations in the technology, the definition of a system which would allow the use of a positive photoresist offers numerous advantages. However, to use standard positive photoresists, the requirement of top level chromium as a solder dam must be eliminated. This is because chromium is etched by basic solutions such as NaOH or KOH which, in use would be destructive to the positive photoresist. Consequently, there existed prior to this invention no technique by which a positive photoresist can be used compatibly with a chromium solder dam layer.

Given these deficiencies in the prior art, the object of this invention is a technique of depositing a high temperature organic solder dam and the resulting package structure. The object of the invention is achieved according to claims 4 and 1.

This invention employs a silylated photoresist. Such a photoresist comprises a plasma-resistant polymeric material which is prepared by reacting a polymeric material containing reactive hydrogen functional groups with a multifunctional organometallic material containing at least two functional groups which are reactive with the reactive hydrogen functional groups of the polymeric material. Such a material can be hexamethylcyclotrisilazane. A silylated photoresist of this type suitable for this invention is described in detail in EP-A-0 198 215 belonging to the state of the art according to Art. 54(3).

This invention, therefore, is directed to a specific use of a silylated photoresist as a solder dam layer joining of semiconductor devices to a substrate. This material is used in place of the chromium layer in the process described herein.

In accordance with this invention, a semiconductor substrate is provided with a blanket Cr-Cu deposition. The positive photoresist is then blanket covered over the Cr-Cu layer. The photoresist is then exposed and developed to obtain the necessary personalization. Metallization lines defining the circuitry are then defined by appropriate etching. The positive photoresist is then stripped followed by etching the bottom chromium layer. The solder dam is then created by reapplying a second positive resist pattern which is exposed and developed to provide the desired connection patterns. The positive photoresist is then silylated and baked. In accordance with this invention, the resulting silylated photoresist is left in place to define the solder barrier.

Using this invention, improved line resolution is attained. Importantly, the requirement for top chromium is eliminated. This in turn reduces the number of processing steps such as top chrome etch which is required in the definition of the solder barrier. Moreover, the process of photoresist stripping is eliminated and this requirement for the use of aggressive and environmentally unsafe material is eliminated.

This invention will be described in greater detail by referring to the attached drawings and the description of the preferred embodiments as follows.

Figures 1 through 4
are schematic sectional views illustrating various steps in the process of this invention; and
Figure 5
is a schematic section view of a portion of a completed device illustrating the silylated photoresist in place as a solder dam.

Description of the preferred embodiment

Referring now to Figures 1 through 4, the process in accordance with this invention is illustrated. Figure 1 illustrates a portion of a substrate that has received intermediate processing. As illustrated in Figure 1 onto a substrate 10 a blanket layer 14 of chromium and a blanket layer 16 of copper are deposited. A positive photoresist 18 is deposited over the chromium copper layers 14 and 16. Figure 1 illustrates the exposure, development and etching of the positive photoresist 18 to define the personality pattern.

With this intermediate structure then defined, the copper layer 16 is etched with an appropriate copper etchant. Such is illustrated in Figure 2. Thus, the openings 20 and 22 which define the personality pattern extend through the copper layer 16 and terminate at the chromium layer. An appropriate copper etchant is $FeCl_3/HCl$, $CuCl_2$ or the like. Following this definition of the personality pattern the photoresist is stripped away with an appropriate stripper. Then, using the etched copper as a mask, the bottom chromium layer 14, is etched in appropriate chromium etchant. Such may be $KMnO_4/KOH$ or any appropriate chromium etchant. Alternatively, the chromium may be etched with the positive photoresist layer in place, that is, immediately following copper etch, but prior to stripping of the resist layer however, the chromium etchant may remove the positive photoresist.

Figure 3 illustrates the next salient intermediate step in accordance with this invention. The second layer of a positive photoresist 24 is blanketly applied over the copper layer 16 filling the openings 20 and 22. This photoresist 24 is then exposed and developed to provide the select patterning for the solder barriers, I/O (input/output) patterns and the like. Those openings 25 are illustrated in Fig. 4 as to the select pattern where the solder dams are placed. The positive photoresist is then silylated and baked. This is accomplished in accordance with techniques which are disclosed in the aforementioned EP-A-0 198 215

It is noted that the silylated photoresist is left in place as the solder barrier. Processing then occurs in accordance with established techniques such as described in U.S. Patent 3,392,442. That is, solder is deposited into openings 25 via immersion in a molten solder bath or the like. Such is well known in the technology. Alternatively, solder need not be deposited in openings but may be delivered to the interconnection site by the chip. The resulting structure is illustrated in Figure 4. Next, the chip is joined to the solder connections, that is to connection 28. This is illustrated in Fig. 5 and represents the final product.

The presence of the silylated photoresist 24 acts as a barrier affirmatively preventing the solder reflow from running down the circuit lines thus causing collapse of the chip which may result in the shorting of the chip to the substrate. As can be appreciated the requirement previously existing in the technology for top chromium is eliminated by this invention. Also, given the use of a positive photoresist fine line resolution capability is achieved.

Figure 5 illustrates the silylated photoresist remaining on the total surface of the substrate. Alternatively, silylated photoresist may be selectively removed once solder barriers are defined by the necessary dams for the solder connections. Advantages, however, occur by allowing the silylated photoresist to remain on the top surface. Corrosion protection over both the circuit lines and the bare copper edge of the circuit lines occurs. Additionally, dip tinning is possible because bridging of fine lines will not occur.

## Claims

1. Electrical connection between a semiconductor chip and a substrate comprising:

   a reflow solder ball contacting said chip and said substrate; and

   a silylated positive photoresist layer comprising a reaction product of a polymeric material containing reactive hydrogen functional groups with a multifunctional organometallic material containing at least two functional groups, said layer surrounding said solder ball on the surface of said substrate to act as a solder dam.

2. Electrical connection of claim 1, wherein said silylated positive photoresist covers the entire surface of said substrate.

3. Electrical connection of claim 1, wherein said silylated positive photoresist covers only conductive circuit lines on the surface of said substrate.

4. Method for manufacturing an electrical connection between a semiconductor chip and a substrate according to claim 1 comprising the steps of:

   blanket coating said substrate with a bottom layer of chromium and a copper layer covering said chromium layer,

   blanket coating said copper layer with a positive photoresist,

   exposing and developing said photoresist to define a personalized pattern followed by etching said copper layer,

   etching said bottom chromium layer using said etched copper layer as a mask,

   applying a second blanket layer of positive photoresist onto said etched copper and chrome layers,

   exposing and developing said second layer of positive photoresist to define a select pattern,

   silylating said second layer of positive photoresist followed by baking,

   placing solder at locations on the select pattern, and

   joining a chip to said substrate.

5. Method of claim 4, wherein said chip is joined by the controlled collapse chip connection of the solder.

6. Method of claim 4 further comprising the step of removing the silylated photoresist from selected portions on the substrate.

7. Method of claim 4 further comprising the step of removing the first layer of positive photoresist prior to etching of the chromium layer.

8. Method of claim 4, wherein said copper layer is etched with $FeCl_3/HCl$ or $CuCl_2$ and said chromium layer is etched with $KMnO_4/KOH$.

## Revendications

1. Connexion électrique entre une plaquette de semiconducteur et un substrat, comprenant :

   une perle de soudure en contact avec cette plaquette et ce substrat; et

   une couche photosensible positive silylée comprenant un produit réactionnel d'un matériau polymère contenant des groupes fonctionnels de type hydrogène réactif avec un matériau organométallique multifonctionnel contenant au moins deux groupes fonctionnels, cette couche entourant cette perle de soudure sur la surface de ce substrat pour jouer le rôle de barrière autour de la soudure.

2. Connexion électrique suivant la revendication 1, dans laquelle cette couche photosensible positive silylée recouvre la surface entière de ce substrat.

3. Connexion électrique suivant la revendication 1, dans laquelle cette couche photosensible positive silylée ne recouvre que les lignes de circuits conducteurs sur la surface de ce substrat.

4. Procédé pour fabriquer une connexion électrique entre une plaquette de semiconducteur et un substrat suivant la revendication 1, comprenant les étapes suivantes :

   recouvrement total de ce substrat avec une couche de fond de chrome et une couche de cuivre recouvrant cette couche de chrome,

   recouvrement total de cette couche de cuivre avec une couche photosensible positive,

   exposition et développement de cette couche photosensible pour définir un motif personnalisé, puis attaque de cette couche de cuivre,

   attaque de cette couche de chrome de fond tandis que cette couche de cuivre attaquée sert de masque,

   application d'une seconde couche de couverture de couche photosensible positive sur ces couches attaquées de cuivre et de chrome,

   exposition et développement de cette seconde couche photosensible pour définir un motif choisi,

   silylation de cette seconde couche photosensible positive, suivie d'une cuisson,

   dépôt de soudure sur des sites du motif choisi, et

   jonction d'une plaquette de semiconducteur à ce substrat.

5. Procédé suivant la revendication 4, dans lequel la jonction de la plaquette est obtenue par affaissement contrôlé de la soudure.

6. Procédé suivant la revendication 4, comprenant de plus l'étape d'élimination de la couche photosensible silylée de parties sélectionnées sur le substrat.

7. Procédé suivant la revendication 4, comprenant de plus l'étape d'élimination de la première couche photosensible positive avant attaque de la couche de chrome.

8. Procédé suivant la revendication 4, dans lequel cette couche de cuivre est attaquée avec du $FeCl_3/HCl$ ou du $CuCl_2$ et cette couche de chrome est attaquée avec du $KMnO_4/KOH$.

## Patentansprüche

1. Elektrische Verbindung zwischen einem Halbleiterchip und einem Substrat, welche gebildet wird

   aus einem durch Aufschmelzen hergestellten kugelförmigen Lot, welches besagtes Chip und Substrat kontaktiert und

   einer silylierten positiven Photoresistschicht, welche aus einem Reaktionsprodukt eines Polymermaterials mit reaktivem Wasserstoff als funktionelle Gruppen mit einem mehrfach funktionellen organometallischen Material mit mindestens zwei funktionellen Gruppen besteht, wobei besagte Schicht das kugelförmige Lot auf der Oberfläche des Substrats in Form eines Damms umgibt.

2. Elektrische Verbindung nach Anspruch 1, bei der der silylierte positive Photoresist die gesamte Oberfläche des Substrats bedeckt.

3. Elektrische Verbindung nach Anspruch 1, bei der der silylierte positive Photoresist nur die leitenden Schaltkreislinien auf der Oberfläche des Substrats bedeckt.

4. Verfahren zur Herstellung einer elektrischen Verbindung zwischen einem Halbleiterchip und einem Substrat nach Anspruch 1, welches folgende Schritte umfasst:

ganzflächiges Bedecken des Substrats mit einer Basisschicht aus Chrom und einer Kupferschicht, welche die Chromschicht bedeckt,

ganzflächiges Bedecken der Kupferschicht mit einem positiven Photoresist,

Belichten und Entwickeln besagter Photoresistschicht zur Definition eines personalisierten Musters und Ätzen besagter Kupferschicht,

Ätzen besagter Basisschicht aus Chrom unter Verwendung der geätzten Kupferschicht als Maske,

ganzflächiges Auftragen einer zweiten Schicht aus positivem Photoresist auf besagte geätzte Kupfer- und Chromschichten,

Belichten und Entwickeln dieser zweiten Photoresistschicht zur Definition eines gewählten Musters,

Silylieren besagter positiver Photoresistschicht und Aushärten,

Auftragen von Lot an Stellen auf dem ausgewählten Muster und

Befestigen des Chips auf dem Substrat.

5. Verfahren nach Anspruch 4, bei dem das Chip befestigt wird durch überwachten Kollaps des zur Chipverbindung vorgesehenen Lots.

6. Verfahren nach Anspruch 4, bei dem in einem weiteren Schritt der silylierte Photoresist von ausgewählten Stellen auf dem Substrat entfernt wird.

7. Verfahren nach Anspruch 4, bei dem in einem weiteren Schritt die erste Schicht aus positivem Photoresist vor dem Ätzen der Chromschicht entfernt wird.

8. Verfahren nach Anspruch 4, bei dem besagte Kupferschicht mit $FeCl_3/HCl$ oder $CuCl_2$ und besagte Chromschicht mit $KMnO_4/KOH$ geätzt wird.

# FIG.1

Cu — 18, POSITIVE PHOTORESIST
Cr — 16
14
10, SUBSTRATE

# FIG.2

20
22
18
16
14
10

# FIG.3

24, POSITIVE PHOTORESIST
Cu — 16
Cr — 14
10, SUBSTRATE

# FIG.4

25
28
25
28
28
25
24, SILYLATED PHOTORESIST
Cu — 16
Cr — 14
10, SUBSTRATE

# FIG.5

26
28
24
16
14
10